# EUROPÄISCHE PATENTSCHRIFT

(11) **EP 0 862 794 B1**
(45) Veröffentlichungstag und Bekanntmachung des Hinweises auf die Patenterteilung: **27.11.2002**
(21) Anmeldenummer: 97909167.5
(22) Anmeldetag: 22.09.1997
(51) Int. Cl.: H01L 33/00, H01S 5/32

(54) **WELLENLÄNGENKONVERTIERENDE VERGUSSMASSE UND VERFAHREN ZU DEREN HERSTELLUNG, VERFAHREN ZUM HERSTELLEN EINES LICHT ABSTRAHLENDEN HALBLEITERBAUELEMENTS UND LICHT ABSTRAHLENDES HALBLEITERBAUELEMENT**
SEALING MATERIAL WITH WAVELENGTH CONVERTING EFFECT AND ITS PRODUCTION PROCESS, PROCESS OF FABRICATING A LIGHT EMITTING SEMICONDUCTOR DEVICE AND LIGHT EMITTING SEMICONDUCTOR DEVICE
MASSE DE SCELLEMENT A EFFET CONVERTISSEUR DE LONGUEUR D'ONDE ET PROCEDE DE SA PRODUCTION, PROCEDE DE PRODUCTION D'UN DISPOSITIF SEMI-CONDUCTEUR EMETTEUR DE LUMIERE ET DISPOSITIF SEMI-CONDUCTEUR EMETTEUR DE LUMIERE

(30) Priorität: 20.09.1996 DE 19638667
(43) Veröffentlichungstag der Anmeldung: 09.09.1998
(60) Teilanmeldung: 02007512.3
(73) Patentinhaber: Osram Opto Semiconductors GmbH & Co. OHG, 93049 Regensburg (DE)
(72) Erfinder: HÖHN, Klaus, D-82024 Taufkirchen (DE); DEBRAY, Alexandra, D-93049 Regensburg (DE); SCHLOTTER, Peter, D-79113 Freiburg (DE); SCHMIDT, Ralf, D-79279 Vörstetten (DE); SCHNEIDER, Jürgen, D-79199 Kirchzarten (DE)
(74) Vertreter: Epping, Wilhelm, Dipl.-Ing.
(86) Internationale Anmeldenummer: DE9702139
(87) Internationale Veröffentlichungsnummer: WO98012757

(56) Entgegenhaltungen:
- EP-A- 0 936 682
- WO-A-98/05078
- DE-A- 3 804 293
- DE-U- 9 013 615

## Beschreibung

Die Erfindung betrifft eine wellenlängenkonvertierende Vergußmasse auf der Basis eines transparenten Epoxidgießharzes, insbesondere für die Verwendung bei einem elektrolumineszierenden Bauelement mit einem ultraviolettes, blaues und/oder grünes Licht aussendenden Körper, und ein Verfahren zu deren Herstellung. Sie betrifft weiterhin ein Verfahren zum Herstellen eines lichtabstrahlenden Halbleiterbauelements und ein lichtabstrahlendes Halbleiterbauelement.

In der früher eingereichten, aber nach dem Anmeldetag dieser Anmeldung veröffentlichten internationalen Anmeldung WO-A-98/05078 (EP-A-0 936 682) mit Bestimmung EP, die Stand der Technik gemäß Artikel 54(3) und (4) EPÜ darstellt, ist ein Leuchtdiodenbauelement beschrieben, bei dem ein Leuchtdiodenchip mit einem Emissionsspektrum im ultravioletten, blauen und grünen Spektralbereich in einer transparenten Vergußmasse eingebettet ist, die anorganische Leuchtstoffpigmente auf der Basis von Cer-dotiertem Yttrium-Aluminium-Granat (Y₃Al₅O₁₂:Ce) enthält.

Aus der Offenlegungsschrift DE 38 04 293 ist eine Anordnung mit einer Elektrolumineszenz- oder Laserdiode bekannt, bei der das von der Diode abgestrahlte Emissionsspektrum mittels eines mit einem fluoreszierenden, lichtwandelnden organischen Farbstoff versetzten Elements aus Kunststoff zu größeren Wellenlängen hin verschoben wird. Das von der Anordnung abgestrahlte Licht weist dadurch eine andere Farbe auf als das von der Leuchtdiode ausgesandte. Abhängig von der Art des dem Kunststoff beigefügten Farbstoffes lassen sich mit ein und demselben Leuchtdiodentyp Leuchtdiodenanordnungen herstellen, die in unterschiedlichen Farben leuchten.

In vielen potentiellen Anwendungsgebieten für Leuchtdioden, wie zum Beispiel bei Anzeigeelementen im Kfz-Armaturenbereich, Beleuchtung in Flugzeugen und Autos und bei vollfarbtauglichen LED-Displays, tritt verstärkt die Forderung nach Leuchtdiodenanordnungen auf, mit denen sich mischfarbiges Licht, insbesondere weißes Licht erzeugen läßt.

Die bislang bekannten Vergußmassen der eingangs genannten Art mit organischen Leuchtstoffen zeigen bei Temperatur- und Temperatur-Feuchtebeanspruchung jedoch eine Verschiebung des Farbortes, also der Farbe des vom elektrolumineszierenden Bauelement abgestrahlten Lichtes.

In JP-07 176 794-A ist eine weißes Licht aussendende planare Lichtquelle beschrieben, bei der an einer Stirnseite einer transparenten Platte zwei blaues Licht emittierende Dioden angeordnet sind, die Licht in die transparente Platte hinein aussenden. Die transparente Platte ist auf einer der beiden einan-. der gegenüberliegenden Hauptflächen mit einer fluoreszierenden Substanz beschichtet, die Licht emittiert, wenn sie mit dem blauen Licht der Dioden angeregt wird. Das von der fluoreszierenden Substanz emittierte Licht hat eine andere Wellenlänge als das von den Dioden emittierte blaue Licht. Bei diesem bekannten Bauelement ist es besonders schwierig, die fluoreszierende Substanz in einer Art und Weise aufzubringen, daß die Lichtquelle homogenes weißes Licht abstrahlt. Darüber hinaus bereitet auch die Reproduzierbarkeit in der Massenfertigung große Probleme, weil schon geringe Schichtdickenschwankungen der fluoreszierenden Schicht, z. B. aufgrund von Unebenheiten der Oberfläche der transparenten Platte, eine Änderung des Weißtones des abgestrahlten Lichtes hervorruft.

Der vorliegenden Erfindung liegt die Aufgabe zugrunde, eine Vergußmasse der eingangs genannten Art zu entwickeln, mit der elektrolumineszierende Bauelemente hergestellt werden können, die homogenes mischfarbiges Licht abstrahlen und die eine Massenfertigung mit vertretbarem technischen Aufwand und mit weitestgehend reproduzierbarer Bauelementcharakteristik ermöglicht. Das abgestrahlte Licht soll auch bei Temperatur- und Temperatur-Feuchtebeanspruchung farbstabil sein. Desweiteren soll ein Verfahren zum Herstellen dieser Vergußmasse angegeben werden.

Diese Aufgabe wird durch eine Vergußmasse mit den Merkmalen des Anspruches 1 beziehungsweise mit einem Verfahren mit den Merkmalen des Patentanspruches 9 gelöst. Ein Verfahren zum Herstellen eines lichtabstrahlenden Halbleiterbauelements und ein lichtabstrahlendes Halbleiterbauelement ist Gegenstand des Patentanspruches 20 bzw. 21.

Vorteilhafte Weiterbildungen der Vergußmasse, des Verfahrens zum Herstellen der Vergußmasse und des lichtabstrahlenden Bauelements sind Gegenstand der Unteransprüche 2 bis 8, 10 bis 19 bzw. 22 bis 25.

Erfindungsgemäß ist vorgesehen, daß im transparenten Epoxidgießharz ein anorganisch-mineralisches Leuchtstoffpigmentpulver auf der Basis eines Granatwirtsgitters mit der allgemeinen Formel A₃B₅X₁₂:M dispergiert sind und daß die Leuchtstoffpigmente Korngrößen ≤ 20 µm und einen mittleren Korndurchmesser d₅₀ ≤ 5 µm aufweisen. Besonders bevorzugt liegt der mittlere Korndurchmesser d₅₀ zwischen 1 und 2 µm. Bei diesen Korngrößen können günstige Fertigungsausbeuten erhalten werden.

Anorganisch-mineralische Leuchtstoffe sind vorteilhafterweise äußerst temperatur- und temperatur-feuchtestabil.

Bei einer besonders bevorzugten Weiterbildung der erfindungsgemäßen Vergußmasse setzt sich diese zusammen aus:
a) Epoxidgießharz ≥ 60 Gew%
b) Leuchtstoffpigmente ≤ 25 Gew%
c) Thixotropiermittel ≤ 10 Gew%
d) mineralischem Diffusor ≤ 10 Gew%
e) Verarbeitungshilfsmittel ≤ 3 Gew%
f) Hydrophobiermittel ≤ 3 Gew%
g) Haftvermittler ≤ 2 Gew%.

Geeignete Epoxidgießharze sind beispielsweise in der DE-OS 26 42 465 auf den Seiten 4 bis 9, insbesondere Beispiele 1 bis 4, und in der EP 0 039 017 auf den Seiten 2 bis 5, insbesondere Beispiele 1 bis 8, beschrieben.

Als Thixotropiermittel ist beispielsweise pyrogene Kieselsäure verwendet. Das Thixotropiermittel dient zur Eindickung des Epoxidgießharzes, um die Sedimentation des Leuchtpigmentpulvers zu vermindern. Für die Gießharzverarbeitung werden weiter die Fließ- und Benetzungseigenschaften eingestellt.

Als mineralischer Diffusor zur Optimierung des Leuchtbildes des Bauelements ist bevorzugt CaF₂ verwendet.

Als verarbeitungshilfsmittel eignet sich beispielsweise Glykolether. Es verbessert die Verträglichkeit zwischen Epoxidgießharz und Leuchtpigmentpulver und dient damit zur Stabilisierung der Dispersion Leuchtpigmentpulver - Epoxidgießharz. Zu diesem Zweck können auch Oberflächenmodifikatoren auf Silikonbasis eingesetzt werden.

Das Hydrophobiermittel, z. B. flüssiges Silikonwachs, dient ebenfalls zur Modifikation der Pigmentoberfläche, insbesondere wird die Verträglichkeit und Benetzbarkeit der anorganischen Pigmentoberfläche mit dem organischen Harz verbessert.

Der Haftvermittler, z. B. funktionelles Alkoxysiloxan, verbessert die Haftung zwischen den Pigmenten und dem Epoxidharz im ausgehärteten Zustand der Vergußmasse. Dadurch wird erreicht, daß die Grenzfläche zwischen dem Epoxidharz und den Pigmenten z. B. bei Temperaturschwankungen nicht abreißt. Spalte zwischen dem Epoxidharz und den Pigmenten würden zu Lichtverlusten im Bauelement führen.

Das Epoxidgießharz, bevorzugt mit einem reaktiven Oxirandreiring, enthält vorzugsweise ein mono- und/oder ein mehrfunktionelles Epoxidgießharzsystem (≥ 80 Gew%; z. B. Bisphenol-A-Diglycidylether), einen Reaktivverdünner (≤ 10 Gew%; z. B. aromatischer Monoglycidylether), einen mehrfunktionellen Alkohol (≤ 5 Gew%), ein Entgasungsagens auf Silikonbasis (≤ 1 Gew%) und eine Entfärbungskomponente zur Einstellung der Farbzahl (≤ 1 Gew%).

Bei einer besonders bevorzugten Weiterbildung des Vergusses sind die Leuchtstoffpigmente kugelförmig oder schuppenförmig. Die Neigung zur Agglomeratbildung derartiger Pigmente ist vorteilhafterweise sehr gering. Der H₂O-Gehalt liegt unter 2%.

Bei der Herstellung und Verarbeitung von Epoxidgießharzkomponenten mit anorganischen Leuchtstoffpigmentpulvern treten im allgemeinen neben Benetzungs- auch Sedimentationsprobleme auf. Besonders Leuchtstoffpigmentpulver mit d₅₀ ≤ 5µm neigen stark zur Agglomeratbildung. Bei der zuletzt genannten Zusammensetzung der Vergußmasse können die Leuchtstoffpigmente vorteilhafterweise in der oben angegebenen Korngröße im Wesentlichen agglomeratfrei und homogen in das Epoxidgießharz dispergiert werden. Diese Dispersion ist auch bei längerer Lagerung der Vergußmasse stabil. Es treten im Wesentlichen keine Benetzungs- und/oder Sedimentationsprobleme auf.

Besonders bevorzugt sind als Leuchtstoffpigmente Partikel aus der Gruppe der Ce-dotierten Granate, insbesondere YAG:Ce-Partikel verwendet. Eine vorteilhafte Dotierstoffkonzentration ist beispielsweise 1% und eine vorteilhafte Leuchtstoffkonzentration beträgt beispielsweise 12%. Desweiteren weist das bevorzugt hochreine Leuchtstoffpigmentpulver vorteilhafterweise einen Eisengehalt von ≤ 5ppm auf. Ein hoher Eisengehalt führt zu hohen Lichtverlusten im Bauelement. Das Leuchtstoffpigmentpulver ist stark abrasiv. Der Fe-Gehalt der Vergußmasse kann bei deren Herstellung daher beträchtlich ansteigen. Vorteilhaft sind Fe-Gehalte in der Vergußmasse < 20ppm.

Der anorganische Leuchtstoff YAG:Ce hat unter anderem den besonderen Vorteil, daß es sich hierbei um nicht lösliche Farbpigmente mit einem Brechungsindex von ca. 1,84 handelt. Dadurch treten neben der Wellenlängenkonversion Dispersion und Streueffekte auf, die zu einer guten Vermischung von blauer Diodenstrahlung und gelber Konverterstrahlung führen.

Besonders vorteilhaft ist weiterhin, dass die Leuchtstoffkonzentration im Epoxidharz bei Verwendung von anorganischen Leuchtstoffpigmenten nicht, wie bei organischen Farbstoffen, durch die Löslichkeit begrenzt wird.

Zur weiteren Verminderung der Agglomeratbildung können die Leuchtstoffpigmente vorteilhafterweise mit einem Silikon-Coating versehen sein.

Bei einem bevorzugten Verfahren zum Herstellen einer erfindungsgemäßen Vergußmasse wird das Leuchtstoffpigmentpulver vor dem Vermischen mit dem Epoxidgießharz z. B. ca. 10 Stunden bei einer Temperatur ≥ 200°C getempert. Dadurch kann ebenfalls die Neigung zu Agglomeratbildung verringert werden.

Alternativ oder zusätzlich kann dazu das Leuchtstoffpigmentpulver vor dem Vermischen mit dem Epoxidgießharz in einem höher siedenden Alkohol geschlämmt und anschließend getrocknet werden. Eine weitere Möglichkeit, die Agglomeratbildung zu verringern, besteht darin, dem Leuchtstoffpigmentpulver vor dem Vermischen mit dem Epoxidgießharz ein hydrophobierendes Silikonwachs zuzugeben. Besonders vorteilhaft ist die Oberflächenstabilisierung der Phosphore durch Erwärmen der Pigmente in Gegenwart von Glykolethern, z. B. 16 h bei T > 60°C.

Zur Vermeidung störender Verunreinigungen beim Dispergieren der Leuchstoffpigmente, verursacht durch Abrieb, werden Reaktionsgefäße, Rühr- und Dispergiervorrichtungen sowie Walzwerke aus Glas, Korund, Carbid- und Nitridwerkstoffen sowie speziell gehärtete Stahlsorten verwendet. Agglomeratfreie Leuchtstoffdispersionen werden auch in Ultraschallverfahren oder durch den Einsatz von Sieben und Glaskeramikfritten erhalten.

Ein besonders bevorzugter anorganischer Leuchtstoff zur Herstellung von weiß leuchtenden optoelektronischen Bauelementen ist der Phosphor YAG:Ce (Y₃Al₅O₁₂:Ce³⁺). Dieser läßt sich auf besonders einfache Weise in herkömmlich in der LED-Technik verwendeten transparenten Epoxidgießharzen mischen. Weiterhin als Leuchtstoffe denkbar sind weitere mit Seltenen Erden dotierte Granate wie z. B. Y₃Ga₅O₁₂:Ce³⁺, Y(Al,Ga)₅O₁₂:Ce³⁺ und Y(Al,Ga)₅O₁₂:Tb³⁺.

Zur Erzeugung von mischfarbigem Licht eignen sich darüberhinaus besonders die mit Seltenen Erden dotierten Thiogallate wie z. B. CaGa₂S₄:Ce³⁺ und SrGa₂S₄:Ce³⁺. Ebenso ist hierzu die Verwendung von mit Seltenen Erden dotierten Aluminaten wie z. B. YAℓO₃:Ce³⁺, YGaO₃:Ce³⁺, Y(Al,Ga)O₃:Ce³⁺ und mit Seltenen Erden dotierten Orthosilikaten M₂SiO₅:Ce³⁺ (M: Sc, Y, Sc) wie z. B. Y₂SiO₅:Ce³⁺ denkbar. Bei allen Yttriumverbindungen kann das Yttrium im Prinzip auch durch Scandium oder Lanthan ersetzt werden.

Bevorzugt wird die erfindungsgemäße Vergußmasse bei einem strahlungsemittierenden Halbleiterkörper, insbesondere mit einer aktiven Halbleiterschicht oder -schichtenfolge aus GaₓIn₁₋ₓN oder GaₓAl₁₋ₓN, eingesetzt, der im Betrieb eine elektromagnetische Strahlung aus dem ultravioletten, blauen und/oder grünen Spektralbereich aussendet. Die Leuchtstoffpartikel in der Vergußmasse wandeln einen Teil der aus diesem Spektralbereich stammenden Strahlung in Strahlung mit größerer Wellenlänge um, derart, daß das Halbleiterbauelement Mischstrahlung, insbesondere mischfarbiges Licht, bestehend aus dieser Strahlung und aus Strahlung aus dem ultravioletten, blauen und/oder grünen Spektralbereich aussendet. Das heißt beispielsweise, daß die Leuchtstoffpartikel einen Teil der vom Halbleiterkörper ausgesandten Strahlung spektral selektiv absorbiert und im längerwelligen Bereich emittiert. Bevorzugt weist die von dem Halbleiterkörper ausgesandte Strahlung bei einer Wellenlänge λ ≤ 520 nm ein relatives Intensitätsmaximum auf und liegt der von den Leuchtstoffpartikeln spektral selektiv absorbierte Wellenlängenbereich außerhalb dieses Intensitätsmaximums.

Ebenso können vorteilhafterweise auch mehrere verschiedenartige Leuchtstoffpartikelarten, die bei unterschiedlichen Wellenlängen emittieren, in der Vergußmasse dispergiert sein. Dies wird bevorzugt duruch unterschiedliche Dotierungen in unterschiedlichen Wirtsgittern erreicht. Dadurch ist es vorteilhafterweise möglich, vielfältige Farbmischungen und Farbtemperaturen des vom Bauelement emittierten Lichtes zu erzeugen. Von besonderem Interesse ist dies für vollfarbtaugliche LEDs.

Bei einer bevorzugten Verwendung der erfindungsgemäßen Vergußmasse ist ein strahlungsemittierender Halbleiterkörper (z. B. ein LED-Chip) zumindest teilweise von dieser umschlossen. Die Vergußmasse ist dabei bevorzugt gleichzeitig als Bauteilumhüllung (Gehäuse) genutzt. Der Vorteil eines Halbleiterbauelements gemäß dieser Ausführungsform besteht im wesentlichen darin, daß zu seiner Herstellung konventionelle, für die Herstellung von herkömmlichen Leuchtdioden (z. B. Radial-Leuchdioden) eingesetzte Produktionslinien verwendet werden können. Für die Bauteilumhüllung wird anstelle des bei herkömmlichen Leuchtdioden dafür verwendeten transparenten Kunststoffes einfach die Vergußmasse verwendet.

Mit der erfindungsgemäßen Vergußmasse kann auf einfache Weise mit einer einzigen farbigen Lichtquelle, insbesondere einer Leuchtdiode mit einem einzigen blaues Licht abstrahlenden Halbleiterkörper, mischfarbiges, insbesondere weißes Licht erzeugt werden. Um z. B. mit einem blaues Licht aussendenden Halbleiterkörper weißes Licht zu erzeugen, wird ein Teil der von dem Halbleiterkörper ausgesandten Strahlung mittels anorganischer Leuchtstoffpartikel aus dem blauen Spektralbereich in den zu Blau komplementärfarbigen gelben Spektralbereich konvertiert.

Die Farbtemperatur oder Farbort des weißen Lichtes kann dabei durch geeignete Wahl des Leuchtstoffes, dessen Partikelgröße und dessen Konzentration, variiert werden. Darüber hinaus können auch Leuchtstoffmischungen eingesetzt werden, wodurch sich vorteilhafterweise der gewünschte Farbton des abgestrahlten Lichtes sehr genau einstellen läßt.

Besonders bevorzugt wird die Vergußmasse bei einem strahlungsemittierenden Halbleiterkörper verwendet, bei dem das ausgesandte Strahlungsspektrum bei einer Wellenlänge zwischen 420nm und 460 nm, insbesondere bei 430 nm (z. B. Halbleiterkörper auf der Basis von GaₓAl₁₋ₓN) oder 450 nm (z. B. Halbleiterkörper auf der Basis von GaₓIn₁₋ₓN) ein Intensitätsmaximum aufweist. Mit einem derartigen Halbleiterbauelement lassen sich vorteilhafterweise nahezu sämtliche Farben und Mischfarben der C.I.E.-Farbtafel erzeugen. An Stelle des strahlungsemittierenden Halbleiterkörpers aus elektrolumineszierendem Halbleitermaterial kann aber auch ein anderes elektrolumineszierendes Material, wie beispielsweise Polymermaterial, eingesetzt werden.

Besonders geeignet ist die Vergußmasse für ein lichtemittierendes Halbleiterbauelement (z. B. eine Leuchtdiode), bei dem der elektrolumineszierende Halbleiterkörper in einer Ausnehmung eines vorgefertigten eventuell bereits mit einem Leadframe versehenen Gehäuses angeordnet ist und die Ausnehmung mit der Vergußmasse versehen ist. Ein derartiges Halbleiterbauelement läßt sich in großer Stückzahl in herkömmlichen Produktionslinien herstellen. Hierzu muß lediglich nach der Montage des Halbleiterkörpers in das Gehäuse die Vergußmasse in die Ausnehmung gefüllt werden.

Ein weißes Licht abstrahlendes Halbleiterbauelement läßt sich mit der erfindungsgemäßen Vergußmasse vorteilhafterweise dadurch herstellen, daß der Leuchtstoff so gewählt wird, daß eine von dem Halbleiterkörper ausgesandte blaue Strahlung in komplementäre Wellenlängenbereiche, insbesondere Blau und Gelb, oder zu additiven Farbtripeln, z. B. Blau, Grün und Rot umgewandelt wird. Hierbei wird das gelbe bzw. das grüne und rote Licht über die Leuchtstoffe erzeugt. Der Farbton (Farbort in der CIE-Farbtafel) des dadurch erzeugten weißen Lichts kann dabei durch geeignete Wahl des/der Leuchtstoffes/e hinsichtlich Mischung und Konzentration variiert werden.

Um die Durchmischung der von einem elektrolumineszierenden Halbleiterkörper ausgesandten Strahlung mit der vom Leuchtstoff konvertierten Strahlung und damit die Farbhomogenität des vom Bauelement abgestrahlten Lichtes zu verbessern, ist bei einer vorteilhaften Ausgestaltung der erfindungsgemäßen Vergußmasse zusätzlich ein im Blauen lumineszierender Farbstoff zugefügt, der eine sogenannte Richtcharakteristik der von dem Halbleiterkörper ausgesandten Strahlung abschwächt. Unter Richtcharakteristik ist zu verstehen, daß die von dem Halbleiterkörper ausgesandte Strahlung eine bevorzugte Abstrahlrichtung aufweist.

Ein weißes Licht abstrahlendes erfindungsgemäßes Halbleiterbauelement mit einem blaues Licht emittierenden elektrolumineszierenden Halbleiterkörper läßt sich besonders bevorzugt dadurch realisieren, daß dem für die Vergußmasse verwendeten Epoxidharz der anorganische Leuchtstoff YAG:Ce (Y₃Al₅O₁₂:Ce³⁺) beigemischt ist. Ein Teil einer von dem Halbleiterkörper ausgesandten blauen Strahlung wird von dem anorganischen Leuchtstoff Y₃Al₅O₁₂:Ce³⁺ in den gelben Spektralbereich und somit in einen zur Farbe Blau komplementärfarbigen Wellenlängenbereich verschoben. Der Farbton (Farbort in der CIE-Farbtafel) des weißen Lichts kann dabei durch geeignete Wahl der Farbstoffkonzentration variiert werden.

Der Vergußmasse können zusätzlich lichtstreuende Partikel, sogenannte Diffusoren zugesetzt sein. Hierdurch läßt sich vorteilhafterweise der Farbeindruck und die Abstrahlcharakteristik des Halbleiterbauelements weiter optimieren.

Mit der erfindungsgemäßen Vergußmasse kann vorteilhafterweise auch eine von einem elektrolumineszierenden Halbleiterkörper neben der sichtbaren Strahlung ausgesandte ultraviolette Strahlung in sichtbares Licht umgewandelt werden. Dadurch wird die Helligkeit des vom Halbleiterkörper ausgesandten Lichts deutlich erhöht.

Ein besonderer Vorteil von erfindungsgemäßen weißes Licht abstrahlenden Halbleiterbauelementen, bei denen als Lumineszenzkonversionsfarbstoff insbesondere YAG:Ce verwendet ist, besteht darin, daß dieser Leuchtstoff bei Anregung mit blauem Licht eine spektrale Verschiebung von ca. 100 nm zwischen Absorption und Emission bewirkt. Dies führt zu einer wesentlichen Reduktion der Reabsorption des vom Leuchtstoff emittierten Lichtes und damit zu einer höheren Lichtausbeute. Außerdem besitzt YAG:Ce vorteilhafterweise eine hohe thermische und photochemische (z. B. UV-) Stabilität (wesentlich höher als organische Leuchtstoffe), so daß auch Weiß leuchtende Dioden für Außenanwendung und/oder hohe Temperaturbereiche herstellbar sind.

YAG:Ce hat sich bislang hinsichtlich Reabsorption, Lichtausbeute, thermischer und photochemischer Stabilität und Verarbeitbarkeit als am besten geeigneter Leuchtstoff herausgestellt. Denkbar ist jedoch auch die Verwendung von anderen Ce-dotierten Phosphoren, insbesondere Ce-dotierten Granattypen.

Die Wellenlängenkonversion der Primärstrahlung wird durch die Kristallfeldaufspaltung der aktiven Übergangsmetallzentren im Wirtsgitter bestimmt. Durch die Substitution von Y durch Gd und/oder Lu bzw. Al durch Ga im Y₃Al₅O₁₂-Granatgitter können die Emissionswellenlängen in unterschiedlicher Weise verschoben werden, wie außerdem durch die Art der Dotierung. Durch die Substitution von Ce³⁺-Zentren durch Eu³⁺ und/oder Cr³⁺ können entsprechende Shifts erzeugt werden. Entsprechende Dotierungen mit Nd³⁺ und Er³⁺ ermöglichen sogar aufgrund der größeren Ionenradien und damit geringeren Kristallfeldaufspaltungen IRemittierende Bauelemente.

Weitere Merkmale, Vorteile und Zweckmäßigkeiten der Erfindung ergeben sich aus der nachfolgenden Beschreibung von zwei Ausführungsbeispielen in Verbindung mit den Figuren 1 bis 8. Es zeigen:
Figur 1 eine schematische Schnittansicht eines ersten Halbleiterbauelements mit einer erfindungsgemäßen Vergußmasse;
Figur 2 eine schematische Schnittansicht eines zweiten Halbleiterbauelements mit einer erfindungsgemäßen Vergußmasse;
Figur 3 eine schematische Schnittansicht eines dritten Halbleiterbauelements mit einer erfindungsgemäßen Vergußmasse;
Figur 4 eine schematische Schnittansicht eines vierten Halbleiterbauelements mit einer erfindungsgemäßen Vergußmasse;
Figur 5 eine schematische Schnittansicht eines fünften Halbleiterbauelements mit einer erfindungsgemäßen Vergußmasse;
Figur 6 eine schematische Darstellung eines Emissionsspektrums eines blaues Licht abstrahlenden Halbleiterkörpers mit einer Schichtenfolge auf der Basis von GaN;
Figur 7 eine schematische Darstellung der Emissionsspektren zweier Halbleiterbauelemente mit einer erfindungsgemäßen Vergußmasse, die weißes Licht abstrahlen, und
Figur 8 eine schematische Darstellung der Emissionsspektren von weiteren Halbleiterbauelementen, die weißes Licht abstrahlen.

In den verschiedenen Figuren sind gleiche bzw. gleichwirkende Teile immer mit denselben Bezugszeichen bezeichnet.

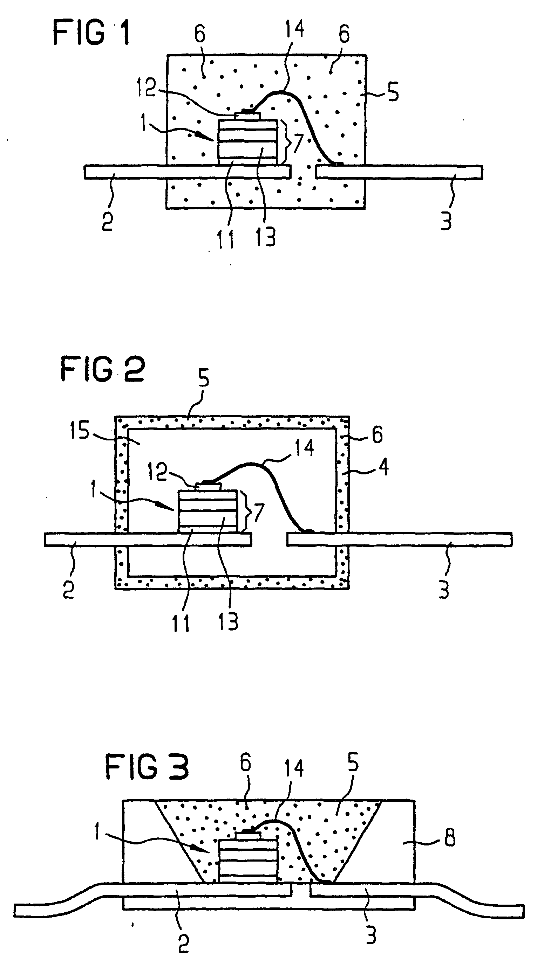

Bei dem lichtemittierenden Halbleiterbauelement von Figur 1 ist der Halbleiterkörper 1 mittels eines elektrisch leitenden Verbindungsmittels, z. B. ein metallisches Lot oder ein Klebstoff, mit seinem Rückseitenkontakt 11 auf einem ersten elektrischen Anschluß 2 befestigt. Der Vorderseitenkontakt 12 ist mittels eines Bonddrahtes 14 mit einem zweiten elektrischen Anschluß 3 verbunden.

Die freien Oberflächen des Halbleiterkörpers 1 und Teilbereiche der elektrischen Anschlüsse 2 und 3 sind unmittelbar von einer gehärteten, wellenlängenkonvertierenden Vergußmasse 5 umschlossen. Diese weist bevorzugt auf: Epoxidgießharz 80 - 90 Gew%, Leuchtstoffpigmente (YAG:Ce) ≤ 15 Gew%, Diethylenglycolmonomethylether ≤ 2 Gew%, Tegopren 6875-45 ≤ 2 Gew%, Aerosil 200 ≤ 5 Gew%

Das in Figur 2 dargestellte Ausführungsbeispiel eines erfindungsgemäßen Halbleiterbauelements unterscheidet sich von dem der Figur 1 dadurch, daß der Halbleiterkörper 1 und Teilbereiche der elektrischen Anschlüsse 2 und 3 anstatt von einer wellenlängenkonvertierenden Vergußmasse von einer transparenten Umhüllung 15 umschlossen sind. Diese transparente Umhüllung 15 bewirkt keine Wellenlängenänderung der von dem Halbleiterkörper 1 ausgesandten Strahlung und besteht beispielsweise aus einem in der Leuchtdiodentechnik herkömmlich verwendeten Epoxid-, Silikon- oder Acrylatharz oder aus einem anderen geeigneten strahlungsdurchlässigen Material wie z. B. anorganisches Glas.

Auf diese transparente Umhüllung 15 ist eine Schicht 4 aufgebracht, die aus einer wellenlängenkonvertierenden Vergußmasse, wie in der Figur 2 dargestellt, die gesamte Oberfläche der Umhüllung 15 bedeckt. Ebenso denkbar ist, daß die Schicht 4 nur einen Teilbereich dieser Oberfläche bedeckt. Die Schicht 4 besteht beispielsweise aus einem transparenten Epoxidharz, das mit Leuchtstoffpartikeln 6 versetzt ist. Auch hier eignet sich als Leuchtstoff für ein weiß leuchtendes Halbleiterbauelement bevorzugt YAG:Ce.

Bei dem in Figur 3 dargestellten besonders bevorzugten mit der erfindungsgemäßen Vergußmasse versehenen Bauelement, sind der erste und zweite elektrische Anschluß 2,3 in ein lichtundurchlässiges evtl. vorgefertigtes Grundgehäuse 8 mit einer Ausnehmung 9 eingebettet. Unter "vorgefertigt" ist zu verstehen, daß das Grundgehäuse 8 bereits an den Anschlüssen 2,3 beispielsweise mittels Spritzguß fertig ausgebildet ist, bevor der Halbleiterkörper auf den Anschluß 2 montiert wird. Das Grundgehäuse 8 besteht beispielsweise aus einem lichtundurchlässigen Kunststoff und die Ausnehmung 9 ist hinsichtlich ihrer Form als Reflektor 17 für die vom Halbleiterkörper im Betrieb ausgesandte Strahlung (ggf. durch geeignete Beschichtung der Innenwände der Ausnehmung 9) ausgebildet. Solche Grundgehäuse 8 werden insbesondere bei auf Leiterplatten oberflächenmontierbaren Leuchtdioden verwendet. Sie werden vor der Montage der Halbleiterkörper auf ein die elektrischen Anschlüsse 2,3 aufweisendes Leiterband (Leadframe) z. B. mittels Spritzgießen aufgebracht.

Die Ausnehmung 9 ist mit einer Vergußmasse 5, deren Zusammensetzung der oben in Verbindung mit der Beschreibung zu Figur 1 angegebenen entspricht, gefüllt.

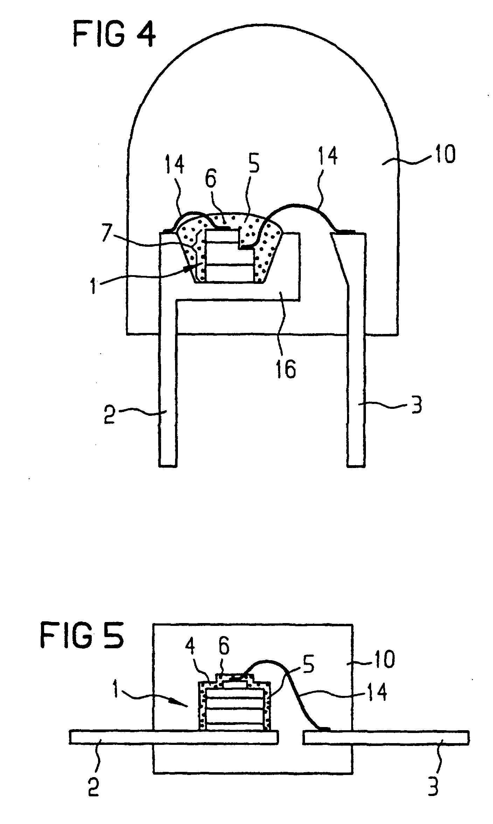

In Figur 4 ist eine sogenannte Radialdiode dargestellt. Hierbei ist der elektrolumineszierende Halbleiterkörper 1 in einem als Reflektor ausgebildeten Teil 16 des ersten elektrischen Anschlußes 2 beispielsweise mittels Löten oder Kleben befestigt. Derartige Gehäusebauformen sind in der Leuchtdiodentechnik bekannt und bedürfen von daher keiner näheren Erläuterung.

Die freien Oberflächen des Halbleiterkörpers 1 sind unmittelbar von einer Vergußmasse 5 mit Leuchtstoffpartikel 6 bedeckt, die wiederum von einer weiteren transparenten Umhüllung 10 umgeben ist.

Der Vollständikeit halber sei an dieser Stelle angemerkt, daß selbstverständlich auch bei der Bauform nach Figur 4 analog zu dem Bauelement gemäß Figur 1 eine einstückige Umhüllung, bestehend aus gehärteter Vergußmasse 5 mit Leuchtstoffpartikel 6, verwendet sein kann.

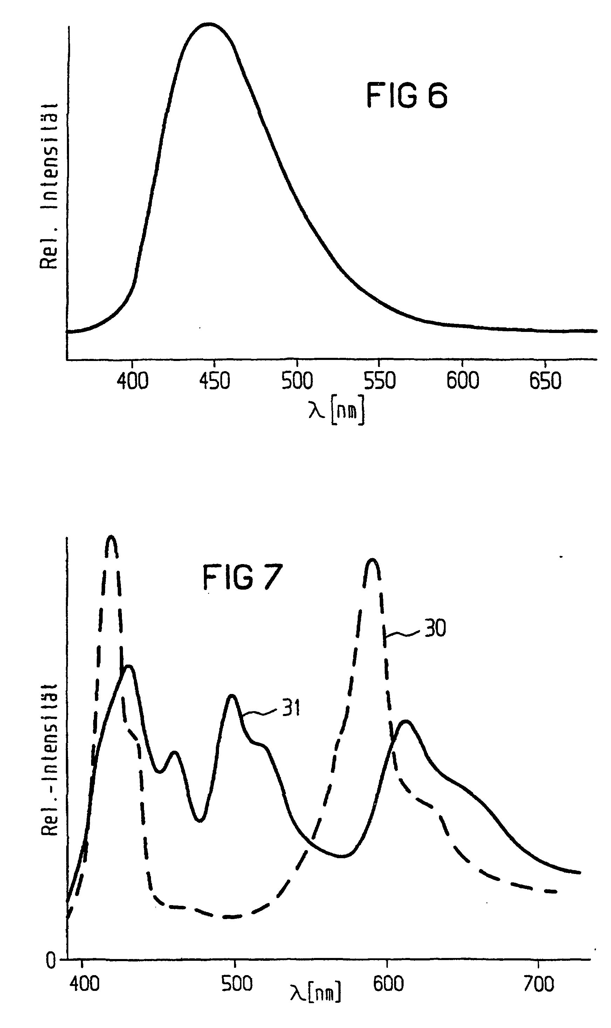

Bei dem Ausführungsbeispiel von Figur 5 ist eine Schicht 4 (mögliche Materialien wie oben angegeben) direkt auf den Halbleiterkörper 1 aufgebracht. Dieser und Teilbereiche der elektrischen Anschlüsse 2,3 sind von einer weiteren transparenten Umhüllung 10 umschlossen, die keine Wellenlängenänderung der durch die Schicht 4 hindurchgetretenen Strahlung bewirkt und beispielsweise aus einem in der Leuchtdiodentechnik verwendbaren transparenten Epoxidharz oder aus Glas gefertigt ist.

Solche, mit einer Schicht 4 versehenen Halbleiterkörper 1 ohne Umhüllung können natürlich vorteilhafterweise in sämtlichen aus der Leuchtdiodentechnik bekannten Gehäusebauformen (z. B. SMD-Gehäuse, Radial-Gehäuse (man vergleiche Figur 4) verwendet sein.

Bei sämtlichen der oben beschriebenen Bauelemente kann zur Optimierung des Farbeindrucks des abgestrahlten Lichts sowie zur Anpassung der Abstrahlcharakteristik die Vergußmasse 5, ggf. die transparente Umhüllung 15, und/oder ggf. die weitere transparente Umhüllung 10 lichtstreuende Partikel, vorteilhafterweise sogenannte Diffusoren aufweisen. Beispiele für derartige Diffusoren sind mineralische Füllstoffe, insbesondere CaF₂, TiO₂, SiO₂, CaCO₃ oder BaSO₄ oder auch organische Pigmente. Diese Materialien können auf einfache Weise Epoxidharzen zugesetzt werden.

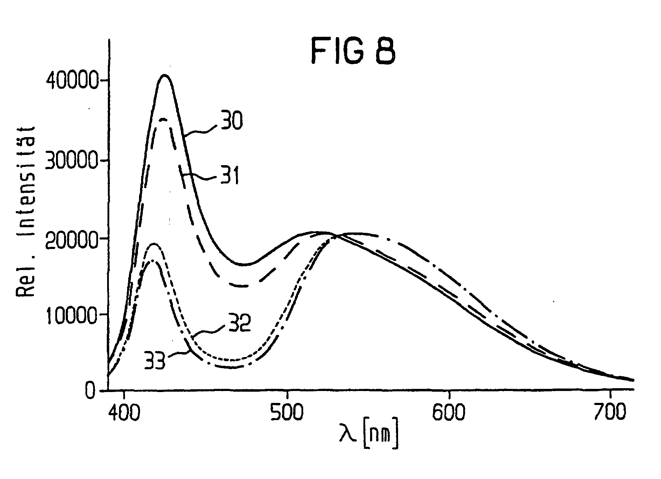

In den Figuren 6, 7 und 8 sind Emissionsspektren eines blaues Licht abstrahlenden Halbleiterkörpers (Fig. 6) (Lumineszenzmaximum bei λ ∼ 430 nm) bzw. von mittels eines solchen Halbleiterkörpers hergestellten Weiß leuchtenden Halbleiterbauelementen (Fig. 7 und 8) gezeigt. An der Abszisse ist jeweils die Wellenänge λ in nm und auf der Ordinate ist jeweils eine relative Elektrolumineszenz(EL)-Intensität aufgetragen.

Von der vom Halbleiterkörper ausgesandten Strahlung nach Figur 6 wird nur ein Teil in einen längerwelligen Wellenlängenbereich konvertiert, so daß als Mischfarbe weißes Licht entsteht. Die gestrichelte Linie 30 in Figur 7 stellt ein Emissionsspektrum von einem Halbleiterbauelement dar, das Strahlung aus zwei komplementären Wellenlängenbereichen (Blau und Gelb) und damit insgesamt weißes Licht aussendet. Das Emissionsspektrum weist hier bei Wellenlängen zwischen ca. 400 und ca. 430 nm (Blau) und zwischen ca. 550 und ca. 580 nm (Gelb) je ein Maximum auf. Die durchgezogene Linie 31 repräsentiert das Emissionsspektrum eines Halbleiterbauelements, das die Farbe Weiß aus drei Wellenlängenbereichen (additives Farbtripel aus Blau, Grün und Rot) mischt. Das Emissionsspektrum weist hier beispielsweise bei den Wellenlängen von ca. 430 nm (Blau), ca. 500 nm (Grün) und ca. 615 nm (Rot) je ein Maximum auf.

Figur 8 zeigt ein Emissionsspektrum eines Weiß leuchtendes Halbleiterbauelement, das mit einem ein Emissions-Spektrum gemäß Figur 6 aussendenden Halbleiterkörper versehen ist und bei dem als Leuchtstoff YAG:Ce verwendet ist. Von der vom Halbeiterkörper ausgesandten Strahlung nach Figur 6 wird nur ein Teil in einen längerwelligen Wellenlängenbereich konvertiert, so daß als Mischfarbe weißes Licht entsteht. Die verschiedenartig gestrichelten Linien 30 bis 33 von Figur 8 stellen Emissionsspektren von erfindungsgemäßen Halbleiterbauelementen dar, bei denen das Epoxidharz der Vergußmasse 5 unterschiedliche YAG:Ce-Konzentrationen aufweist. Jedes Emissionsspektrum weist zwischen λ = 420 nm und λ = 430 nm, also im blauen Spektralbereich, und zwischen λ = 520 nm und λ = 545 nm, also im grünen Spektralbereich, jeweils ein Intensitätsmaximum auf, wobei die Emissionsbanden mit dem längerwelligen Intensitätsmaximum zu einem großen Teil im gelben Spektralbereich liegen. Das Diagramm von Figur 8 verdeutlicht, daß bei dem erfindungsgemäßen Halbleiterbauelement auf einfache Weise durch Veränderung der Leuchtstoffkonzentration im Epoxidharz der CIE-Farbort des weißen Lichtes verändert werden kann.

Die Erläuterung der Erfindung anhand der oben beschriebenen Bauelemente ist natürlich nicht als Beschränkung der Erfindung auf diese zu betrachten. Als Halbleiterkörper, wie beispielsweise Leuchtdioden-Chips oder Laserdioden-Chips, ist beispielsweise auch eine Polymer-LED zu verstehen, die ein enstprechendes Strahlungsspektrum aussendet.

## Patentansprüche

1. Wellenlängenkonvertierende Vergußmasse (5) auf der Basis eines transparenten Epoxidharzes für ein elektrolumineszierendes Bauelement mit einem ultraviolettes, blaues und/oder grünes Licht aussendenden Körper (1), bei der im transparenten Epoxidharz ein anorganisches Leuchtstoffpigmentpulver mit Leuchtstoffpigmenten (6) aus der Gruppe der Phosphore mit der allgemeinen Formel A₃B₅X₁₂:M dispergiert ist und die Leuchtstoffpigmente Korngrößen ≤ 20 µm und einen mittleren Korndurchmesser d₅₀ ≤ 5 µm aufweisen.

2. Vergußmasse nach Anspruch 1, bei der die Leuchtstoffpigmente (6) kugelförmig oder schuppenförmig sind.

3. Vergußmasse nach Anspruch 1 oder 2, bei der der mittlere Korndurchmesser d₅₀ zwischen 1 und 2 µm liegt.

4. Vergußmasse nach einem der Ansprüche 1 bis 3, die zusammengesetzt ist aus:
a) Epoxidharz ≥ 60 Gew%
b) Leuchtstoffpigmente > 0 und ≤ 25 Gew%
c) Thixotropiermittel > 0 und ≤ 10 Gew%
d) mineralischem Diffusor > 0 und ≤ 10 Gew%
e) Verarbeitungshilfsmittel > 0 und ≤ 3 Gew%
f) Hydrophobiermittel > 0 und ≤ 3 Gew%
g) Haftvermittler > 0 und ≤ 2 Gew%.

5. Vergußmasse nach einem der Ansprüche 1 bis 4, bei der als Leuchtstoffpigmente Partikel aus der Gruppe der Ce-dotierten Granate verwendet sind.

6. Vergußmasse nach Anspruch 5, bei der als Leuchtstoffpigmente YAG:Ce-Partikel verwendet sind.

7. Vergußmasse nach einem der Ansprüche 1 bis 6, bei der der Eisengehalt ≤ 20ppm ist.

8. Vergußmasse nach einem der Ansprüche 1 bis 7, bei der die Leuchtstoffpigmente (6) mit einem Silikon-Coating versehen sind.

9. Verfahren zum Herstellen einer Vergußmasse für ein lichtabstrahlendes Bauelement mit einem ultraviolettes, blaues oder grünes Licht aussendenden Körper (1), bei dem in ein transparentes Epoxidharz ein anorganisches Leuchtstoffpigmentpulver dispergiert wird, mit Leuchtstoffpigmenten (6) aus der Gruppe der Phosphore mit der allgemeinen Formel A₃B₅X₁₂:M, die Korngrößen ≤ 20 µm und einen mittleren Korndurchmesser d₅₀ ≤ 5 µm aufweisen.

10. Verfahren nach Anspruch 9, bei dem das Leuchtstoffpigmentpulver vor dem Vermischen mit dem Epoxidharz bei einer Temperatur ≥ 200°C getempert wird.

11. Verfahren nach Anspruch 9 oder 10, bei dem das Leuchtstoffpigmentpulver vor dem Vermischen mit dem Epoxidharz in einem höher siedenden Alkohol geschlämmt und anschließend getrocknet wird.

12. Verfahren nach einem der Ansprüche 9 bis 11, bei dem dem Leuchtstoffpigmentpulver vor dem Vermischen mit dem Epoxidharz ein hydrophobierendes Silikonwachs zugegeben wird.

13. Verfahren nach einem der Ansprüche 9 bis 12, bei dem das Leuchstoffpigmentpulver mit Alkoholen, Glykolethern und Silikonen im Epoxidharz bei erhöhten Temperaturen oberflächenmodifiziert wird.

14. Verfahren nach einem der Ansprüche 9 bis 13, bei dem kugelförmige oder schuppenförmige Leuchtstoffpigmente (6) verwendet werden.

15. Verfahren nach einem der Ansprüche 9 bis 14, bei dem Leuchtstoffpigmente verwendet werden, deren mittlerer Korndurchmesser d₅₀ zwischen 1 und 2 µm liegt.

16. Verfahren nach einem der Ansprüche 9 bis 15, bei dem
a) Epoxidharz ≥ 60 Gew%
b) Leuchtstoffpigmente > 0 und ≤ 25 Gew%
c) Thixotropiermittel > 0 und ≤ 10 Gew%
d) mineralischem Diffusor > 0 und ≤ 10 Gew%
e) Verarbeitungshilfsmittel > 0 und ≤ 3 Gew%
f) Hydrophobiermittel > 0 und ≤ 3 Gew%
g) Haftvermittler > 0 und ≤ 2 Gew%
vermischt werden.

17. Verfahren nach einem der Ansprüche 9 bis 16, bei dem als Leuchtstoffpigmente Partikel aus der Gruppe der Ce-dotierten Granate verwendet werden.

18. Verfahren nach Anspruch 17, bei dem als Leuchtstoffpigmente YAG:Ce-Partikel verwendet werden.

19. Verfahren nach einem der Ansprüche 9 bis 18, bei dem die Leuchtstoffpigmente (6) mit einem Silikon-Coating versehen werden.

20. Verfahren zum Herstellen eines lichtabstrahlenden Halbleiterbauelements, bei dem ein Halbleiterkörper (1), der eine Halbleiterschichtenfolge (7) aufweist, die geeignet ist, im Betrieb des Halbleiterbauelements elektromagnetische Strahlung aus dem ultravioletten, blauen und/oder grünen Spektralbereich auszusenden, zumindest teilweise mit einer Vergußmasse gemäß einem der Patentansprüche 1 bis 8 umschlossen wird.

21. Lichtabstrahlendes Halbleiterbauelement, hergestellt mit einer Vergußmasse nach einem der Ansprüche 1 bis 8 mit einem Halbleiterkörper (1), der eine Halbleiterschichtenfolge (7) aufweist, die geeignet ist, im Betrieb des Halbleiterbauelements elektromagnetische Strahlung aus dem ultravioletten, blauen und/oder grünen Spektralbereich auszusenden, und die Leuchtstoffpigmente einen Teil der aus diesem Spektralbereich stammenden Strahlung in Strahlung mit größerer Wellenlänge umwandelt, derart, daß das Halbleiterbauelement Mischstrahlung, insbesondere mischfarbiges Licht, bestehend aus dieser Strahlung und aus Strahlung aus dem ultravioletten, blauen und/oder grünen Spektralbereich aussendet.

22. Lichtabstrahlendes Halbleiterbauelement nach Anspruch 21, bei dem die Vergußmasse zumindest einen Teil des Halbleiterkörpers (1) umschließt.

23. Lichtabstrahlendes Halbleiterbauelement nach Anspruch 21 oder 22, bei dem die vom Halbleiterkörper (1) ausgesandte Strahlung im blauen Spektralbereich bei λ = 430 nm oder bei λ = 450 nm ein Lumineszenz-Intentsitätsmaximum aufweist.

24. Lichtabstrahlendes Halbleiterbauelement nach einem der Ansprüche 21 bis 23, bei dem der Halbleiterkörper (1) in einer Ausnehmung (9) eines lichtundurchlässigen Grundgehäuses (8) angeordnet ist und die Ausnehmung (9) zumindest teilweise mit der Vergußmasse (5) gefüllt ist.

25. Lichtabstrahlendes Halbleiterbauelement nach einem der Ansprüche 21 bis 24, bei dem die Vergußmasse (5) hinsichtlich Wirtsgitter und Art und Ausmaß der Dotierung mit verschiedenartigen Leuchtstoffpigmenten (6) versehen ist.

## Claims

1. Wavelength-converting casting compound (5) based on a transparent epoxy resin for an electroluminescent component with a body (1) emitting ultraviolet, blue and/or green light, in which an inorganic luminescent pigment powder with luminescent pigments (6) from the group of phosphors with the general formula A₃B₅X₁₂:M is dispersed in the transparent epoxy resin, and the luminescent pigments have particle sizes ≤ 20 µm and a mean particle diameter d₅₀ ≤ 5 µm.

2. Casting compound according to Claim 1, in which the luminescent pigments (6) are spherical or in the form of flakes.

3. Casting compound according to Claim 1 or 2, in which the mean particle diameter d₅₀ lies between 1 and 2 µm.

4. Casting compound according to one of Claims 1 to 3, which is made up of:
a) epoxy resin ≥ 60% by weight
b) luminescent pigments > 0 and ≤ 25% by weight
c) thixotropic agent > 0 and ≤ 10% by weight
d) mineral diffusor > 0 and ≤ 10% by weight
e) processing auxiliary > 0 and ≤ 3% by weight
f) hydrophobing agent > 0 and ≤ 3% by weight
g) adhesion promoter > 0 and ≤ 2% by weight.

5. Casting compound according to one of Claims 1 to 4, in which particles from the group of Ce-doped garnets are used as luminescent pigments.

6. Casting compound according to Claim 5, in which YAG:Ce particles are used as luminescent pigments.

7. Casting compound according to one of Claims 1 to 6, in which the iron content is ≤ 20 ppm.

8. Casting compound according to one of Claims 1 to 7, in which the luminescent pigments (6) are provided with a silicone coating.

9. Method for producing a Casting compound for a light-emitting component with a body (1) emitting ultraviolet, blue or green light, in which an inorganic luminescent pigment powder is dispersed in a transparent epoxy resin, with luminescent pigments (6) from the group of phosphors with the general formula A₃B₅X₁₂:M which have particle sizes ≤ 20 µm and a mean particle diameter d₅₀ ≤ 5 µm.

10. Method according to Claim 9, in which the luminescent pigment powder is heat-treated at a temperature ≥ 200°C before mixing with the epoxy resin.

11. Method according to Claim 9 or 10, in which the luminescent pigment powder is washed in a higher-boiling alcohol and then dried before mixing with the epoxy resin.

12. Method according to one of Claims 9 to 11, in which a hydrophobing silicone wax is added to the luminescent pigment powder before mixing with the epoxy resin.

13. Method according to one of Claims 9 to 12, in which the luminescent pigment powder is surface-modified with alcohols, glycol ethers and silicones in the epoxy resin at elevated temperatures.

14. Method according to one of Claims 9 to 13, in which luminescent pigments (6) which are spherical or in the form of flakes are used.

15. Method according to one of Claims 9 to 14, in which luminescent pigments whose mean particle diameter d₅₀ lies between 1 and 2 µm are used.

16. Method according to one of Claims 9 to 15, in which
a) epoxy resin ≥ 60% by weight
b) luminescent pigments > 0 and ≤ 25% by weight
c) thixotropic agent > 0 and ≤ 10% by weight
d) mineral diffusor > 0 and ≤ 10% by weight
e) processing auxiliary > 0 and ≤ 3% by weight
f) hydrophobing agent > 0 and ≤ 3% by weight
g) adhesion promoter > 0 and ≤ 2% by weight
are mixed.

17. Method according to one of Claims 9 to 16, in which particles from the group of Ce-doped garnets are used as luminescent pigments.

18. Method according to Claim 17, in which YAG:Ce particles are used as luminescent pigments.

19. Method according to one of Claims 9 to 18, in which the luminescent pigments (6) are provided with a silicone coating.

20. Method for producing a light-emitting semiconductor component, in which a semiconductor body (1), which has a semiconductor layer sequence (7) that is suitable for emitting electromagnetic radiation from the ultraviolet, blue and/or green spectral range during operation of the semiconductor component, is at least partially encased by a casting compound according to one of Patent Claims 1 to 8.

21. Light-emitting semiconductor component, produced using a casting compound according to one of Patent Claims 1 to 8, with a semiconductor body (1), which has a semiconductor layer sequence (7) that is suitable for emitting electromagnetic radiation from the ultraviolet, blue and/or green spectral range during operation of the semiconductor component, and the luminescent pigments convert a part of the radiation coming from this spectral range into radiation with a longer wavelength, such that the semiconductor component emits mixed radiation, in particular mixed-colour light, consisting of this radiation and of radiation from the ultraviolet, blue and/or green spectral range.

22. Light-emitting semiconductor component according to Claim 21, in which the casting compound encases at least a part of the semiconductor body (1).

23. Light-emitting semiconductor component according to Claim 21 or 22, in which the radiation emitted by the semiconductor body (1) has a luminescence-intensity maximum in the blue spectral range at λ = 430 nm or at λ = 450 nm.

24. Light-emitting semiconductor component according to one of Claims 21 to 23, in which the semiconductor body (1) is arranged in a recess (9) of an opaque base package (8), and the recess (9) is filled at least partially with the casting compound (5).

25. Light-emitting semiconductor component according to one of Claims 21 to 24, in which the casting compound (5) is provided with various luminescent pigments (6) that differ with respect to host lattice and type and level of the doping.

## Revendications

1. Composition (5) de scellement à effet convertisseur de longueur d'onde à base d'une résine époxyde transparente pour un composant électroluminescent, ayant un corps (1) émettant de la lumière ultraviolette bleue et/ou verte, dans laquelle il est dispersé dans la résine époxyde transparente une poudre de pigment minéral luminescent ayant des pigments (6) luminescents du groupe composé des substances fluorescentes de formule générale A₃B₅X₁₂:M et les pigments luminescents ont des granulométries ≤ 20 µm et un diamètre moyen de grains d₅₀ ≤ 5 µm.

2. Composition de scellement suivant la revendication 1, dans laquelle les pigments (6) luminescents sont en forme de sphères ou en forme d'écailles.

3. Composition de scellement suivant la revendication 1 ou 2, dans laquelle le diamètre moyen de grains d₅₀ est compris entre 1 et 2 µm.

4. Composition de scellement suivant l'une des revendications 1 à 3 qui est composée de :
a) d'une résine époxyde ≥ 60 % en poids
b) de pigments luminescents > 0 et ≤ 25 % en poids
c) d'un agent thixotrope > et ≤ 10 % en poids
d) d'un diffuseur minéral > 0 et ≤10 % en poids
e) d'un adjuvant de traitement > 0 et ≤ 3 % en poids
f) d'un agent hydrophobe > 0 et ≤ 3 % en poids
g) d'un agent adhésif > 0 et ≤ 2 % en poids.

5. Composition de scellement suivant l'une des revendications 1 à 4, dans laquelle il est utilisé comme pigments luminescents des particules du groupe des grenats dopées par du Ce.

6. Composition de scellement suivant la revendication 5, dans laquelle il est utilisé comme pigments luminescents des particules de YAG:Ce.

7. Composition de scellement suivant l'une des revendications 1 à 6, dans laquelle la teneur en fer est ≤ 20 ppm.

8. Composition de scellement suivant l'une des revendications 1 à 7, dans laquelle les pigments (6) luminescents sont munis d'un enrobage de silicone.

9. Procédé de préparation d'une composition de scellement pour un composant émettant de la lumière et comprenant un corps (1) émettant de la lumière ultraviolette bleue ou verte, dans lequel on disperse dans une résine époxyde transparente une poudre minérale de pigment luminescent ayant des pigments (6) luminescents choisis dans le groupe des substances fluorescentes de formule générale A₃B₅X₁₂:M, qui ont des granulométries ≤ 20 µm et un diamètre moyen de grain d₅₀ ≤ 5 µm.

10. Procédé suivant la revendication 9, dans lequel on traite thermiquement la poudre de pigment luminescent, avant le mélange à la résine époxyde, à une température ≥ 200°C.

11. Procédé suivant la revendication 9 ou 10, dans lequel on met la poudre de pigment luminescent dans un alcool à haut point d'ébullition avant le mélange avec la résine époxyde et ensuite on la sèche.

12. Procédé suivant l'une des revendications 9 à 11, dans lequel on ajoute à la poudre de pigment luminescent, avant le mélange à la résine époxyde, une cire de silicone hydrophobe.

13. Procédé suivant l'une des revendications 9 à 12, dans lequel on modifie la surface de la poudre de pigment luminescent par des alcools, des étherglycols et des silicones dans la résine époxyde en procédant à des températures élevées.

14. Procédé suivant l'une des revendications 9 à 13, dans lequel on utilise des pigments (6) luminescents en forme de sphères ou en forme d'écailles.

15. Procédé suivant l'une des revendications 9 à 14, dans lequel on utilise des pigments luminescents dont le diamètre moyen de grains d₅₀ est compris entre 1 et 2 µm.

16. Procédé suivant l'une des revendications 9 à 15, dans lequel on mélange
a) une résine époxyde ≥ 60 % en poids
b) des pigments luminescents > 0 et ≤ 25 % en poids
c) un agent thixotrope > et ≤ 10 % en poids
d) un diffuseur minéral > 0 et ≤10 % en poids
e) un adjuvant de traitement > 0 et ≤ 3 % en poids
f) un agent hydrophobe > 0 et ≤ 3 % en poids
g) un agent adhésif > 0 et ≤ 2 % en poids.

17. Procédé suivant l'une des revendications 9 à 16, dans lequel on utilise comme pigments luminescents des particules du groupe des grenats dopées par du Ce.

18. Procédé suivant la revendication 17, dans lequel on utilise comme pigments luminescents des particules de YAG:Ce.

19. Procédé suivant l'une des revendications 9 à 18, dans lequel on munit les pigments (6) luminescents d'un enrobage de silicone.

20. Procédé de fabrication d'un composant à semi-conducteur émettant de la lumière, dans lequel on enrobe au moins en partie d'une masse de scellement, suivant l'une des revendications 1 à 8, un corps (1) à semi-conducteur qui a une succession (7) de couches semi-conductrices qui convient pour émettre, lorsque le composant à semi-conducteur fonctionne, un rayonnement électromagnétique dans le domaine ultraviolet, bleu et/ou vert du spectre.

21. Composant à semi-conducteur émettant de la lumière, fabriqué à l'aide d'une composition de scellement, suivant l'une des revendications 1 à 8, et comprenant un corps (1) à semi-conducteur qui a une succession (7) de couches semi-conductrices qui convient pour l'émission, lorsque le composant à semi-conducteur fonctionne, d'un rayonnement électromagnétique dans le domaine ultraviolet, bleu et/ou vert du spectre et les pigments luminescents transforment une partie du rayonnement provenant de ce domaine du spectre en rayonnement ayant des longueurs d'ondes plus grandes, de façon ce que le composant à semi-conducteur émette un rayonnement mixte, notamment de la lumière de couleur mélangée constituée de ce rayonnement et d'un rayonnement du domaine ultraviolet, bleu et/ou vert du spectre.

22. Composant à semi-conducteur émettant de la lumière suivant la revendication 21, dans lequel la composition de scellement entoure au moins une partie du corps (1) à semi-conducteur.

23. Composant à semi-conducteur émettant de la lumière suivant la revendication 21 ou 22, dans lequel le rayonnement émis par le corps (1) à semi-conducteur a un maximum d'intensité de la luminescence dans le domaine bleu du spectre à λ = 430 nm ou à λ = 450 nm.

24. Composant à semi-conducteur émettant de la lumière suivant l'une des revendications 21 à 23, dans lequel le corps (1) à semi-conducteur est disposé dans un évidement (9) d'un boîtier (8) de base perméable à la lumière et l'évidement (9) est empli au moins en partie de la composition (5) de scellement.

25. Composant à semi-conducteur émettant de la lumière suivant l'une des revendications 21 à 24, dans lequel la composition (5) de scellement est munie de pigments (6) luminescents de types différents du point de vue du réseau hôte et de la nature et de l'intensité du dopage.
